# EUROPÄISCHE PATENTSCHRIFT

(11) **EP 4 266 938 B1**
(45) Veröffentlichungstag und Bekanntmachung des Hinweises auf die Patenterteilung: **12.02.2025**
(21) Anmeldenummer: 21835977.6
(22) Anmeldetag: 02.12.2021
(51) Int. Cl.: A41D 27/08, D06Q 1/00

(54) **FUNKTIONELLE PAILLETTE, ANORDNUNG MIT EINER SOLCHEN PAILLETTE SOWIE VERFAHREN ZUM HERSTELLEN DER ANORDNUNG**
FUNCTIONAL PAILLETTE, ARRANGEMENT COMPRISING SUCH A PAILLETTE AND METHOD FOR PRODUCING THE ARRANGEMENT
PAILLETTE FONCTIONNELLE, AGENCEMENT COMPRENANT UNE TELLE PAILLETTE ET PROCÉDÉ DE FABRICATION DE L'AGENCEMENT

(30) Priorität: 22.12.2020 DE 102020216463
(43) Veröffentlichungstag der Anmeldung: 01.11.2023
(73) Patentinhaber: Robert Bosch GmbH, 70442 Stuttgart (DE)
(72) Erfinder: SCHEINER, Philipp, 71263 Weil Der Stadt (DE); HOLZ, Rainer, 71672 Marbach (DE)
(86) Internationale Anmeldenummer: PCT/EP2021/084009
(87) Internationale Veröffentlichungsnummer: WO 2022/135869

(56) Entgegenhaltungen:
- DE-A1- 102016 209 460
- DE-A1- 102019 200 093

## Beschreibung

Die Erfindung geht aus von einer funktionellen Paillette für ein Kleidungsstück oder ein Textilelement, eine Anordnung umfassend eine solche funktionelle Paillette sowie von einem Verfahren zum Herstellen der Anordnung nach Gattung der unabhängigen Ansprüche.

### Stand der Technik

Aus der DE 10 2019 200 093 A1 ist eine Paillette mit wenigstens einem elektrischen oder elektronischen Funktionselement gezeigt, welche an einem Kleidungsstück befestigbar und elektrisch kontaktierbar ist. Die DE 10 2016 209 460 A1 offenbart eine elektronische Vorrichtung, die mittels eines elektrischen Leiters an einem Textil anbringbar ist.

Das Dokument DE 10 2016 209460 A1 offenbart eine funktionelle Paillette gemäß dem Oberbegriff des Anspruchs 1.

### Offenbarung der Erfindung

Vor diesem Hintergrund wird mit dem hier vorgestellten Ansatz eine funktionelle Paillette für ein Kleidungsstück oder ein Textilelement vorgestellt, welche wenigstens ein Trägerelement für wenigstens ein elektronisches Bauelement umfasst und wobei das Trägerelement eine rotationssymmetrische Grundfläche mit einer mehrzähligen Rotationssymmetrie aufweist. Ferner umfasst die Paillette eine Mehrzahl an zueinander rotationssymmetrisch an dem Trägerelement angeordneten Kontaktierungsanordnungen zur elektrischen Kontaktierung des wenigstens einen elektronischen Bauelements mit jeweils wenigstens einem ersten elektrischen Kontakt und einem zweiten elektrischen Kontakt. Die Paillette zeichnet sich dadurch aus, dass die ersten elektrischen Kontakte der Mehrzahl an Kontaktierungsanordnungen elektrisch verbunden sind und die zweiten elektrischen Kontakte der Mehrzahl an Kontaktierungsanordnungen elektrisch verbunden sind. Mit anderen Worten weist die Paillette mindestens jeweils zwei erste elektrische Kontakte und zwei zweite elektrische Kontakte auf, wobei sich die zwei ersten elektrischen Kontakte auf demselben elektrischen Potenzial befinden und wobei sich die zwei zweiten elektrischen Kontakte auf demselben elektrischen Potenzial befinden.

Unter einer Paillette kann ein flächiges Plättchen verstanden werden, das geeignet ist, an einem Kleidungsstück oder einem Textil angebracht bzw. angeordnet zu werden. Unter einer rotationssymmetrischen Grundfläche kann eine Grundfläche verstanden werden, die auf sich selbst abgebildet wird, wenn sie um einen festen Winkel zwischen 0° und 360° um ihren zentralen Punkt dreht. Der zentrale Punkt ist hierbei der Drehpunkt, um den die Grundfläche auf sich selbst abgebildet wird, wenn sie um 360° gedreht wird. Unter einer mehrzähligen Rotationssymmetrie kann verstanden werden, dass die Grundfläche auf sich selbst abgebildet wird, wenn der Drehwinkel einem Quotienten aus 360° geteilt durch n entspricht, wobei n eine Zähligkeit der Rotationssymmetrie bezeichnet. Im Falle einer zweifachen Rotationssymmetrie wird demnach die Grundfläche bei einer Rotation um 180° und im Falle einer dreifachen Rotationssymmetrie wird die Grundfläche bei einer Rotation um 120° auf sich selbst abgebildet. Die Grundfläche zeichnet sich durch eine im Vergleich zu ihrer flächigen Ausdehnung im Wesentlichen geringen Höhe aus. Eine Paillette kann bspw. Metall oder Kunststoff aufweisen. Unter einer funktionellen Paillette kann hierbei eine Paillette verstanden werden, die wenigstens ein elektronisches Bauelement, insbesondere weitere elektrische, elektronische, optische oder mechanische Bauelemente oder eine Kombination aus diesen Bauelementen aufweist oder mit diesen energietechnisch und/oder signaltechnisch in Verbindung steht. Unter einem Trägerelement kann bspw. eine, insbesondere miniaturisierte, Leiterplatte verstanden werden.

Unter einer Kontaktierungsanordnung kann ein elektrischer Anschluss verstanden werden, mit dem einerseits die Paillette nach außen hin energietechnisch und/oder signaltechnisch kontaktierbar ist und mit dem andererseits etwaige, auf dem Trägerelement angeordnete elektronische Bauelemente energietechnisch und/oder signaltechnisch verbunden werden können. Eine Kontaktierungsanordnung wird durch wenigstens den ersten elektrischen Kontakt und den zweiten elektrischen Kontakt ausgebildet, wobei die Kontaktierungsanordnung bei Bedarf noch weitere elektrische Kontakte, insbesondere einen dritten elektrischen Kontakt und bevorzugt einen vierten elektrischen Kontakt, aufweisen kann. Hierbei können die zu einer Kontaktierungsanordnung gehörenden elektrischen Kontakte symmetrisch oder arbiträr an dem Trägerelement angeordnet sein. Der erste elektrische Kontakt und/oder der zweite elektrische Kontakt kann alternativ oder zusätzlich dazu vorgesehen und eingerichtet sein, die Paillette an dem Kleidungsstück oder dem Textilelement zu befestigen. Hierbei kann vorzugsweise das gleiche Mittel verwendet werden, um die Paillette an dem Kleidungsstück oder dem Textilelement zu befestigen und elektrisch zu kontaktieren.

Unter einer Mehrzahl an zueinander rotationssymmetrisch angeordneten Kontaktierungsanordnungen kann verstanden werden, dass wenigstens zwei Kontaktierungsanordnungen an dem Trägerelement angeordnet sind und die Kontaktierungsanordnungen in zur Drehung der Grundfläche analoger Weise durch eine Drehung um den zentralen Punkt der Grundfläche auf sich selbst abgebildet werden, wenn der Drehwinkel einem Quotienten aus 360° geteilt durch m entspricht, wobei m wiederum die entsprechende Zähligkeit der Rotationssymmetrie bezeichnet.

### Vorteile der Erfindung

Durch die rotationssymmetrische Ausgestaltung der Grundfläche des Trägerelements der funktionellen Paillette kann die Paillette besonders einfach auf dem Kleidungsstück oder dem Textilelement, auf welchem die Paillette angeordnet bzw. angebracht werden soll, ausgerichtet werden. Dies ist insbesondere dann von Vorteil, wenn mehrere gleichartige Pailletten in einem bestimmten Muster oder in einer bestimmten Art auf dem Kleidungsstück oder dem Textilelement angeordnet werden sollen. Denn durch die Rotationssymmetrie der Grundfläche können die Grundflächen der Pailletten abhängig von der Zähligkeit der Rotationssymmetrie durch Drehungen lediglich um Bruchteile von 360° in die gleiche Ausrichtung überführt werden.

Des Weiteren wird durch die Rotationssymmetrie der Mehrzahl der an dem Trägerelement angeordneten Kontaktierungsanordnungen die elektrische, insbesondere energietechnische und/oder signaltechnische, Kontaktierung der Paillette vereinfacht. Denn je nach Anzahl an Kontaktierungsanordnungen kann die Paillette an verschiedenen Positionen auf dem Trägerelement, insbesondere von mehreren Seiten her, elektrisch kontaktiert werden.

Indem jeweils die ersten elektrischen Kontakte und jeweils die zweiten elektrischen Kontakte auf demselben elektrischen Potenzial liegen, kann die Paillette daher unabhängig von einer speziellen Anordnung des wenigstens einen elektronischen Bauelements oder einer speziellen Anordnung mehrerer elektronischer Bauelemente auf dem Trägerelement an verschiedenen Positionen auf dem Trägerelement und insbesondere von mehreren Seiten elektrisch kontaktiert werden.

Weitere Vorteile ergeben sich aus den Unteransprüchen.

In einer bevorzugten Ausführungsform kann vorgesehen sein, dass eine Anzahl der Kontaktierungsanordnungen einer Zähligkeit der Rotationssymmetrie der Grundfläche des Trägerelements entspricht. Hierdurch wird in vorteilhafter Weise gewährleistet, dass sich bei einer Drehung der Grundfläche des Trägerelements um einen Winkel des Quotienten aus 360° und der Zähligkeit der Rotationssymmetrie die Kontaktierungsanordnungen um den gleichen Winkel drehen. Dies führt dazu, dass nicht nur die Grundfläche des Trägerelements, sondern auch die Kontaktierungsanordnungen auf sich selbst abgebildet werden. Somit kann bei einer zuvor definierten Ausrichtung der Grundfläche des Trägerelements auf dem Kleidungsstück oder dem Textilelement die Paillette immer an der gleichen Position an dem Trägerelement elektrisch kontaktiert werden.

In einer weiteren Ausführungsform ist vorgesehen, dass die Grundfläche des Trägerelements als regelmäßiges Polygon ausgestaltet ist. Unter einem regelmäßigen Polygon kann beispielsweise ein gleichseitiges Dreieck, ein Quadrat, ein gleichseitiges Fünfeck, ein gleichseitiges Sechseck oder dergleichen verstanden werden. Durch die gleich langen Seiten der Grundfläche des Trägerelements können die Pailletten in besonders einfacher Weise auf dem Kleidungsstück oder dem Textilelement platziert, positioniert und/oder ausgerichtet werden. Insbesondere wird bei einer automatischen Platzierung, Positionierung und/oder Ausrichtung der Paillette durch eine Zuführeinheit bzw. eines Magazins einer Bestückungsmaschine hierdurch ein Effizienzvorteil erreicht.

In einer weiteren Ausführungsform ist vorgesehen, dass die Mehrzahl an Kontaktierungsanordnungen jeweils einen dritten elektrischen Kontakt oder jeweils weitere elektrische Kontakte aufweisen, wobei jeweils der dritte elektrische Kontakt oder jeweils die weiteren elektrischen Kontakte der Mehrzahl an Kontaktierungsanordnungen elektrisch verbunden sind. Hierbei können beispielsweise der erste elektrische Kontakt und der zweite elektrische Kontakt zur energietechnischen Kontaktierung und der dritte elektrische Kontakt und alternativ der vierte elektrische Kontakt zur signaltechnischen Kontaktierung der Paillette bzw. des wenigstens einen, auf dem Trägerelement angeordneten elektronischen Bauelements vorgesehen sein. Hierdurch können die Einsatzmöglichkeiten der Paillette deutlich vergrößert werden.

Weiterhin ist es vorteilhaft, wenn die ersten elektrischen Kontakte, die zweiten elektrischen Kontakte und/oder die dritten oder weiteren elektrischen Kontakte der jeweiligen Kontaktierungsanordnungen unmittelbar benachbart zueinander angeordnet sind. Denn hierdurch können die zur, insbesondere energietechnischen und/oder signaltechnischen, elektrischen Kontaktierung vorgesehenen elektrisch leitfähigen Fäden im Wesentlichen gebündelt bzw. platzsparend auf dem Kleidungsstück oder dem Textilelement an die Kontaktierungsanordnungen der Paillette zugeführt werden.

In einer weiteren Ausführungsform ist vorgesehen, dass die ersten elektrischen Kontakte, die zweiten elektrischen Kontakte und/oder die dritten oder weiteren elektrischen Kontakte der jeweiligen Kontaktierungsanordnungen im Wesentlichen an einem Randbereich des Trägerelements angeordnet sind. Hierdurch können die elektrischen Kontakte besonders einfach durch die in oder an dem Kleidungsstück oder dem Textilelement angeordneten oder integrierten elektrisch leitfähigen Fäden elektrisch kontaktiert werden. Hierbei ist es besonders vorteilhaft, wenn die ersten elektrischen Kontakte, die zweiten elektrischen Kontakte und/oder die dritten oder weiteren elektrischen Kontakte der jeweiligen Kontaktierungsanordnungen entlang einer zu einer Seite der Grundfläche parallelen Linie angeordnet sind. Dies vereinfacht die elektrische Kontaktierung mittels der elektrisch leitfähigen Fäden weiter.

Insbesondere kann vorgesehen sein, dass die ersten elektrischen Kontakte, die zweiten elektrischen Kontakte und/oder die dritten oder weiteren elektrischen Kontakte als Kontaktbohrungen zur Aufnahme eines elektrisch leitfähigen Fadens ausgebildet sind. Hierbei können die Kontaktbohrungen beispielsweise mit einer Metallisierung oder einem elektrisch leitfähigen, ausgehärteten Lack versehen sein, wobei sich die Metallisierung oder der Lack durch die Bohrung hindurch und wenigstens um einen Randbereich der Bohrung zu beiden Seiten des Trägerelements erstreckt. Hierdurch können die elektrischen Kontakte besonders einfach mittels der elektrisch leitfähigen Fäden kontaktiert werden. Insbesondere wird hierdurch die elektrische Kontaktierung unabhängig davon gewährleistet, ob die Paillette mit einer auf eine Außenseite des Textilelements oder des Kleidungsstücks weisenden Oberseite oder Unterseite des Trägerelements an dem Kleidungsstück oder dem Textilelement angeordnet, angebracht oder integriert wird.

Weiterhin kann bevorzugt vorgesehen sein, dass das Trägerelement wenigstens ein Zentrierelement zum Ausrichten der Paillette während eines Anbringens an das Kleidungsstück oder das Textilelement aufweist. Bevorzugt kann hierbei das wenigstens eine Zentrierelement als in dem Trägerelement angeordnete Bohrung und/oder als an dem Trägerelement angeordneter Vorsprung ausgestaltet sein. Durch das wenigstens eine Zentrierelement kann die Paillette bei einer Zuführung mittels einer Zuführeinheit oder eines Magazins einer Bestückungsvorrichtung besonders robust und einfach auf dem Kleidungsstück oder dem Textilelement platziert, positioniert und/oder ausgerichtet werden. Insbesondere wenn eine mechanische Befestigung der Paillette allein durch leitfähige Fäden an den Kontaktierungsanordnungen nicht oder nicht ausreichend gewährleistet werden kann, kann die Paillette an dem

Zentrierelement oder den Zentrierelementen mit einem, insbesondere elektrisch nicht leitfähigen, Garn an dem Kleidungsstück oder dem Textilelement fixiert werden. Somit kann in einem Fertigungsprozess die Paillette beispielsweise erst mit Hilfe der Bohrungen korrekt zugeführt werden, wobei die gleichen Bohrungen dann zum Ansticken mittels des bevorzugt nicht-leitfähigen Garns, insbesondere an unterschiedlichen Positionen, verwendet werden und anschließend, wenn die Paillette somit sicher und fest mit dem Kleidungsstück oder dem Textilelement verbunden ist, die Paillette über die leitfähigen Fäden an den Kontaktierungsanordnungen elektrisch kontaktiert werden.

Weiterhin kann vorgesehen sein, dass eine Mehrzahl an Zentrierungselementen rotationssymmetrisch an oder auf dem Trägerelement angeordnet ist und eine Anzahl der Zentrierungselemente mindestens einer Zähligkeit der Rotationssymmetrie der Grundfläche des Trägerelements entspricht. Hierdurch wird die Handhabung der Pailletten bei der Platzierung, Positionierung und/oder Ausrichtung auf dem Kleidungsstück oder dem Textilelement weiter verbessert.

Die zuvor genannten Vorteile gelten in entsprechender Weise auch für eine Anordnung, welche eine an einem Kleidungsstück oder einem Textilelement angebrachte oder integrierte Paillette, insbesondere gemäß einer der zuvor genannten Ausführungsformen, umfasst, und welche wenigstens einen ersten elektrisch leitfähigen Faden und einen zweiten elektrisch leitfähigen Faden zur mechanischen Befestigung der Paillette an dem Kleidungsstück oder dem Textilelement und/oder zur elektrischen Kontaktierung der Paillette, wobei der erste elektrisch leitfähige Faden mit einem der ersten elektrischen Kontakte und der zweite elektrisch leitfähige Faden mit einem der zweiten elektrischen Kontakte verbunden ist. Diese Anordnung kann in besonders einfacher und damit kostengünstiger Weise hergestellt werden.

In einer bevorzugten Ausführungsform der Anordnung ist die wenigstens eine Paillette mit einer auf eine Außenseite des Textilelements oder des Kleidungsstücks weisenden Oberseite des Trägerelements oder mit einer Unterseite des Trägerelements an dem Kleidungsstück oder dem Textilelement angebracht oder integriert. Hierdurch kann in vorteilhafter Weise eine Anordnung bereitgestellt werden bei welcher es unerheblich ist, ob die Paillette mit ihrer Unterseite oder mit ihrer Oberseite auf dem Textilelement oder dem Kleidungsstück aufliegt. Hierdurch wird die Handhabung der Paillette bei einem Verfahren zum Herstellen einer solchen Anordnung weiter vereinfacht.

In einer weiteren bevorzugten Ausführungsform ist vorgesehen, dass die Anordnung wenigstens eine weitere an dem Kleidungsstück oder dem Textilelement angebrachte oder integrierte Paillette, insbesondere gemäß einer der zuvor genannten Ausführungsformen, umfasst. Hierbei weist die wenigstens eine weitere Paillette wenigstens einen weiteren ersten elektrisch leitfähigen Faden und einen weiteren zweiten elektrisch leitfähigen Faden zur mechanischen Befestigung der weiteren Paillette an dem Kleidungsstück oder dem Textilelement und/oder zur elektrischen Kontaktierung der weiteren Paillette auf, wobei der weitere erste elektrisch leitfähige Faden mit einem der ersten elektrischen Kontakte und der weitere zweite elektrisch leitfähige Faden mit einem der zweiten elektrischen Kontakte der wenigstens einen weiteren Paillette verbunden ist. Des Weiteren sind bei dieser Anordnung die Grundflächen beider Pailletten an dem Kleidungsstück oder dem Textilelement, insbesondere entlang einer horizontalen und/oder vertikalen Achse, derart zueinander parallelverschoben, dass ihre Grundflächen sich nicht überlappen. Mit anderen Worten weist die Anordnung eine Mehrzahl an ähnlichen oder gleichen Pailletten auf, welche, insbesondere zeilenweise und/oder spaltenweise, zueinander verschoben angeordnet sind. Hierbei sind Abstände zwischen den Pailletten so gewählt, dass sich die Pailletten gerade nicht berühren. Die Grundflächen der Pailletten weisen hierbei alle die gleiche Ausrichtung auf. Da die Grundflächen der Pailletten rotationssymmetrisch ausgebildet sind, können einzelne Pailletten anderen Pailletten gegenüber um einen bestimmten Winkel gedreht sein, wobei der Winkel dem Quotienten aus 360° geteilt durch die Zähligkeit der Rotationssymmetrie entspricht.

Die zuvor genannten Vorteile gelten in entsprechender Weise auch für ein Verfahren zum Herstellen einer Anordnung gemäß einer der zuvor beschriebenen Ausführungsformen. Das Verfahren weist wenigstens einen Schritt des Bereitstellens wenigstens einer Paillette über eine Zuführeinrichtung auf das Kleidungsstück oder das Textilelement auf, wobei das Bereitstellen derart erfolgt, dass die wenigstens eine Paillette eine definierte oder definierbare Ausrichtung auf dem Kleidungsstück oder dem Textilelement aufweist. Ferner umfasst das Verfahren einen Schritt des Befestigens und/oder elektrischen Kontaktierens der wenigstens einen Paillette mittels wenigstens eines ersten elektrisch leitfähigen Fadens und eines zweiten elektrisch leitfähigen Fadens, wobei der erste elektrisch leitfähige Faden mit einem der ersten elektrischen Kontakte und der zweite elektrisch leitfähige Faden mit einem der zweiten elektrischen Kontakte verbunden wird

### Kurze Beschreibung der Zeichnungen

Ausführungsformen der Erfindung sind in den Zeichnungen schematisch dargestellt und in der nachfolgenden Beschreibung näher erläutert.

Für die in den verschiedenen Figuren dargestellten und ähnlich wirkenden Elemente werden gleiche Bezugszeichen verwendet, wobei auf eine wiederholte Beschreibung der Elemente verzichtet wird.

Es zeigen:
- Figur 1: eine schematische Darstellung einer funktionellen Paillette für ein Kleidungsstück oder ein Textilelement in einer Draufsicht gemäß einem Ausführungsbeispiel;
- Figur 2: eine schematische Darstellung einer Anordnung mit einer Mehrzahl an funktionellen Pailletten aus Figur 1 in einer Draufsicht gemäß einem Ausführungsbeispiel;
- Figur 3: eine schematische Darstellung einer Anordnung mit einer funktionellen Paillette aus Figur 1 in einer Draufsicht gemäß einem weiteren Ausführungsbeispiel; sowie
- Figur 4: ein Ablaufdiagramm eines Verfahrens zum Herstellen einer Anordnung.

Wie bereits vorstehend ausgeführt wird mit der vorliegenden Erfindung eine funktionelle Paillette für ein Kleidungsstück oder ein Textilelement, eine Anordnung, die eine solche funktionelle Paillette umfasst, sowie ein Verfahren zum Herstellen einer Anordnung beschrieben. Hierdurch kann in besonders einfacher Weise eine funktionelle Paillette bereitgestellt und/oder Anordnung hergestellt werden, welches sich durch ihre vereinfachte Handhabung auszeichnet.

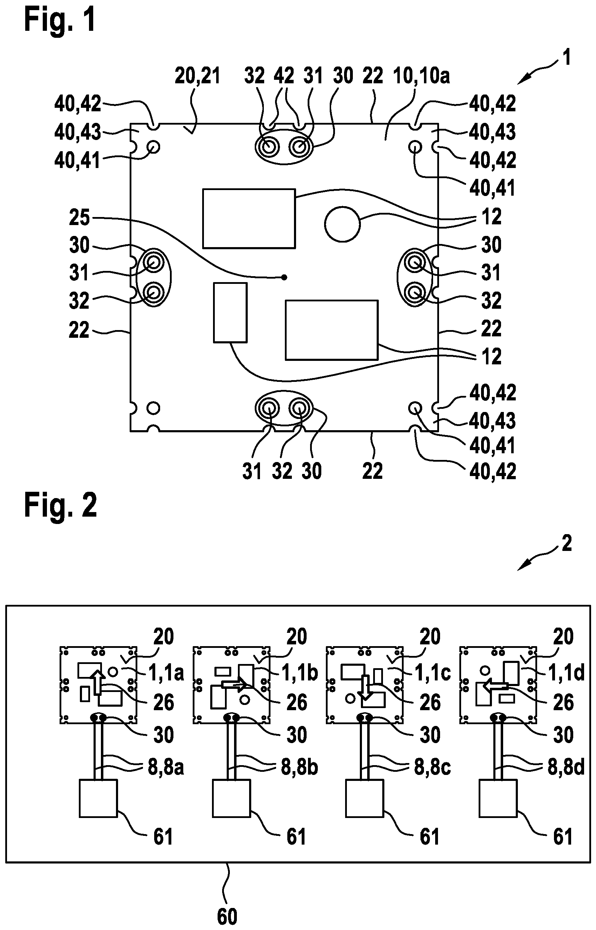

In Figur 1 ist eine funktionelle Paillette 1 in einer Draufsicht dargestellt. Die funktionelle Paillette 1 weist ein als Leiterplatte 10a ausgestaltetes Trägerelement 10 auf. Auf der Leiterplatte 10a ist eine Mehrzahl an elektronischen Bauelementen 12 im Wesentlichen willkürlich angeordnet. Die elektronischen Bauelemente 12 können beispielsweise als Aktoren, Sensoren, LEDs oder dergleichen ausgebildet sein.

Eine Grundfläche 20 des Trägerelements 10 ist als regelmäßiges Polygon ausgebildet. In diesem Fall ist die Grundfläche 20 als Quadrat 21 ausgestaltet. Das Quadrat 21 ist rotationssymmetrisch mit einer Zähligkeit der Rotationssymmetrie von vier. Dies bedeutet, dass die Grundfläche 20 bei einer Drehung um einen zentralen Drehpunkt 25 um jeweils 90° (360°/4) auf sich selbst abgebildet wird. Das Trägerelement 10 weist ferner vier Kontaktierungsanordnungen 30 auf, welche ebenfalls rotationssymmetrisch um den zentralen Drehpunkt 25 angeordnet sind. Weiterhin können die vier Kontaktierungsanordnungen 30 wie in der Figur 1 zu sehen im Wesentlichen jeweils mittig zwischen zwei parallelen Seiten 22 und in unmittelbarer Nähe einer weiteren Seite 22 des Quadrats 21 angeordnet sein. Es sind jedoch auch andere Anordnungen der Kontaktierungsanordnungen 30 möglich.

Jede der vier Kontaktierungsanordnungen 30 weist einen ersten elektrischen Kontakt 31 und einen zweiten elektrischen Kontakt 32 auf. Hierbei sind alle der vier ersten elektrischen Kontakte 31 und alle der vier zweiten elektrischen Kontakte 32 elektrisch miteinander verbunden (nicht dargestellt). Somit kann die Paillette 1 an vier verschiedenen Positionen elektrisch kontaktiert werden. Sofern sich die Ausrichtung der Grundfläche 20 des Trägerelements 10 (unabhängig davon, on sich die Anordnung der darauf befindlichen elektronischen Bauelemente 12 ändert) nicht ändert, kann demnach auch eine um 90°, 180° oder 270° um den zentralen Drehpunkt 25 gedrehte Paillette 1 gleichermaßen elektrisch kontaktiert werden, beispielsweise an der unteren Seite 22 des Quadrats 21. Optional kann jede der vier Kontaktierungsanordnungen 30 zusätzlich einen dritten elektrischen Kontakt oder gar einen vierten elektrischen Kontakt aufweisen, wobei alle vier dritten elektrischen Kontakte und alle vier vierten elektrischen Kontakte elektrisch miteinander verbunden sind. Bevorzugt sind alle elektrischen Kontakte 31, 32 einer Kontaktierungsanordnung 30 entlang einer Linie, insbesondere parallel zu einer Seite 22 des Quadrats 21, angeordnet. Weiterhin bevorzugt sind alle elektrischen Kontakte 31, 32 als Kontaktbohrungen ausgebildet, sodass durch die jeweiligen Kontaktbohrungen ein elektrisch leitfähiger Faden zur, insbesondere energietechnischen und/oder signaltechnischen, elektrischen Anbindung führbar ist.

Ferner weist die Grundfläche 20 wenigstens ein als Bohrung 41, als Zentrieröffnung 42 und/oder als Vorsprung 43 ausgebildetes Zentrierelement 40 auf. Das Zentrierelement 40 dient hierbei der Ausrichtung der Paillette 1 bzw. der Grundfläche 20 des Trägerelements 10, wenn die Paillette 1 auf ein Kleidungsstück oder ein Textilelement (hier nicht dargestellt) angeordnet und/oder aufgebracht werden soll. Insbesondere wird hierbei eine Zuführung der Paillette 1 mittels einer Zuführeinheit oder eines Magazins einer Bestückungsmaschine erleichtert. Das als Bohrung 41, als Zentrieröffnung 42 und/oder als Vorsprung 43 ausgebildete Zentrierelement 40 kann hierbei zusätzlich oder alternativ als Befestigungsmittel dienen. Insbesondere wenn eine mechanische Befestigung der Paillette 1 allein durch leitfähige Fäden an den Kontaktierungsanordnungen 30 nicht oder nicht ausreichend gewährleistet werden kann, kann die Paillette 1 an dem Zentrierelement 40 oder den Zentrierelementen 40 mit einem, insbesondere elektrisch nicht leitfähigen, Garn an dem Kleidungsstück oder dem Textilelement fixiert werden. Somit kann in einem Fertigungsprozess die Paillette 1 beispielsweise erst mit Hilfe der Bohrungen 41 korrekt zugeführt werden, wobei die gleichen Bohrungen 41 dann zum Ansticken mittels des bevorzugt nicht-leitfähigen Garns verwendet werden und anschließend, wenn die Paillette 1 somit sicher und fest mit dem Kleidungsstück oder dem Textilelement verbunden ist, die Paillette 1 über die leitfähigen Fäden an den Kontaktierungsanordnungen 30 elektrisch kontaktiert werden. Besonders vorteilhaft sind hierbei Bohrungen 41, die, insbesondere gleichmäßig, verteilt an einem Randbereich, vorzugsweise entlang einer zu einer Seite (22) der Grundfläche (20) parallelen Linie, des Trägerelements (10) angeordnet sind, sodass eine gleichmäßige mechanische Befestigung der Paillette 1 an dem Kleidungsstück oder dem Textilelement erreicht werden kann.

Bevorzugt weist die Grundfläche 20 eine Mehrzahl an Zentrierelementen 40 auf. Die Zentrierelemente 40 sind hierbei rotationssymmetrisch um den zentralen Drehpunkt 25 angeordnet. Bevorzugt weist die Rotationssymmetrie dieser Anordnung der Zentrierelemente 40 die gleiche Zähligkeit auf, wie die Rotationssymmetrie der Grundfläche 20 des Trägerelements 10.

Bevorzugt ist vorgesehen, dass die Pailletten 1 mittels der als Kontaktbohrungen ausgebildeten elektrischen Kontakte 31, 32 elektrisch und mechanisch und/oder mittels der Zentrierelemente 40 mechanisch mit einem Kleidungsstück oder einem Textilelement verwendbar ist.

In Figur 2 ist eine schematische Darstellung einer Anordnung 2 mit einer funktionellen Pailletten 1 aus Figur 1 in einer Draufsicht gemäß einem Ausführungsbeispiel gezeigt. In dem Ausführungsbeispiel ist die Palette 1 auf einem Kleidungsstück 60 oder einem Textilelement 60 angeordnet und in vier verschiedenen Ausrichtungen dargestellt. Jede der vier funktionellen Pailletten 1a, 1b, 1c, 1d entspricht der Pailletten 1 aus Figur 1, wobei die einzelnen Pailletten 1a, 1b, 1c, 1d von links nach rechts jeweils um 90° gedreht zueinander angeordnet sind. Dies wird durch den Pfeil 26 verdeutlicht. Da jede Grundfläche 20 der Pailletten 1a, 1b, 1c, 1d vier rotationssymmetrisch angeordnete Kontaktierungsanordnungen 30 aufweist, kann jede der Pailletten 1a, 1b, 1c, 1d mittels jeweils zweier bevorzugt parallel verlaufender und im Wesentlichen aus einer Richtung kommender elektrisch leitfähiger Fäden 8a, 8b, 8c, 8d elektrisch kontaktiert werden. Die elektrisch leitfähigen Fäden 8a, 8b, 8c, 8d können hierbei in oder an dem Kleidungsstück 60 oder dem Textilelement 60 integriert oder angeordnet sein und zu einer externen Energiequelle 61 führen. Die externe Energiequelle 61 kann hierbei der energietechnischen und/oder signaltechnischen Kontaktierung der Paillette 1 bzw. der darauf angeordneten elektronischen Bauelemente 12 dienen. Diese Integration der elektrisch leitfähigen Fäden8a, 8b, 8c, 8d und/oder deren elektrische Kontaktierung an den Kontaktanordnungen 30 kann mittels eines automatisierten Stickprozesses bzw. mittels eines Stickprogrammes ausgeführt werden.

Die wenigstens eine Paillette 1 kann hierbei mit einer auf eine Außenseite des Textilelements 60 oder des Kleidungsstücks 60 weisenden Oberseite des Trägerelements 10 oder mit einer Unterseite des Trägerelements 10 an dem Kleidungsstück 60 oder dem Textilelement 60 angebracht oder integriert sein. Mit anderen Worten ist es für die Paillette 1 und/oder die Anordnung 2 unerheblich, ob die Paillette wie in Figur 2 dargestellt oder um 180° um eine parallel zu einer in einer Ebene des Trägerelements 10 liegenden Achse gedreht auf dem Textilelement 60 oder dem Kleidungsstücks 60 ausgerichtet und angeordnet bzw. darin integriert ist.

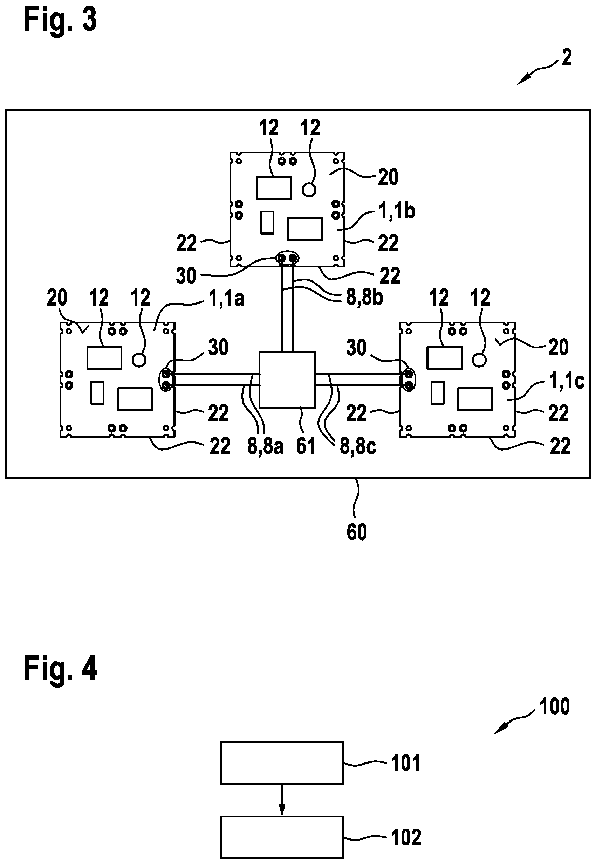

In Figur 3 ist eine schematische Darstellung einer weiteren Anordnung 2 mit einer Mehrzahl an funktionellen Pailletten 1 aus Figur 1 in einer Draufsicht gemäß einem weiteren Ausführungsbeispiel gezeigt. Hierbei sind drei funktionelle Pailletten 1a, 1b, 1c jeweils zueinander parallelverschoben auf dem Textil 60 angeordnet. In diesem Falle hat sich die Anordnung der elektronischen Bauelemente 12 auf der quadratischen Grundfläche 20 der funktionelle Paillette 1 nicht geändert. Durch die auf jeder Seite 22 der quadratischen Grundfläche 20 der funktionellen Pailletten 1a, 1b, 1c angeordneten Kontaktierungsanordnungen 30 kann jede der funktionellen Pailletten 1a, 1b, 1c mittels jeweils zweier bevorzugt parallel verlaufender elektrisch leitfähiger Fäden 8a, 8b, 8c über die externe Energiequelle 61 elektrisch kontaktiert werden. Je nachdem, wie die funktionellen Pailletten 1a, 1b, 1c zueinander parallel verschoben sind, kann eine vorteilhafte Positionierung und/oder Ausrichtung der elektrisch leitfähigen Fäden 8a, 8b, 8c erreicht werden. Die elektrisch leitfähigen Fäden 8a, 8b, 8c können hierbei analog zu der Beschreibung zu Figur 2 in oder an dem Kleidungsstück 60 oder dem Textilelement 60 integriert oder angeordnet sein und zu einer externen Energiequelle 61 führen.

In Figur 4 ist ein Ablaufdiagramm eines Verfahrens 100 zum Herstellen einer Anordnung 2 gemäß einer der zuvor beschriebenen Ausführungsformen dargestellt. In einem Schritt 101 wird wenigstens eine Paillette 1 über eine Zuführeinrichtung auf einem Kleidungsstück 60 oder einem Textilelement 60 derart bereitgestellt, dass die Paillette 1 eine definierte oder definierbare Ausrichtung auf dem Kleidungsstück 60 oder dem Textilelement 60 aufweist. In einem weiteren Schritt 102 erfolgt ein Befestigen und/oder elektrisches kontaktieren der wenigstens einen Paillette 1 mittels wenigstens eines ersten elektrisch leitfähigen Fadens 8 und eines zweiten elektrisch leitfähigen Fadens 8, wobei der erste elektrisch leitfähige Faden 8 mit einem der ersten elektrischen Kontakte 31 und der zweite elektrisch leitfähige Faden 8 mit einem der zweiten elektrischen Kontakte 32 verbunden wird. Hierbei kann das als Bohrung 41, als Zentrieröffnung 42 und/oder als Vorsprung 43 ausgebildete Zentrierelement 40 zusätzlich oder alternativ als mechanisches Befestigungsmittel dienen. Insbesondere wenn eine mechanische Befestigung der Paillette allein durch die elektrisch leitfähigen Fäden 8a, 8b, 8c, 8d an den Kontaktierungsanordnungen 30 nicht oder nicht ausreichend gewährleistet werden kann, kann die Paillette 1 an dem Zentrierelement 40 oder den Zentrierelementen 40 mit einem, insbesondere elektrisch nicht leitfähigen, Garn an dem Kleidungsstück oder dem Textilelement fixiert werden. Die Schritte 101 und 102 können sich sodann wiederholen, um eine weitere Paillette 1 auf dem Kleidungsstück 60 oder dem Textilelement 60 bereitzustellen, zu befestigen und/oder elektrisch zu kontaktieren.

## Patentansprüche

1. Funktionelle Paillette (1) für ein Kleidungsstück (60) oder ein Textilelement (60), umfassend
• wenigstens ein Trägerelement (10) für wenigstens ein elektronisches Bauelement (12), wobei das Trägerelement (10) eine rotationssymmetrische Grundfläche (20) mit einer mehrzähligen Rotationssymmetrie aufweist,
• eine Mehrzahl an zueinander rotationssymmetrisch an dem Trägerelement (10) angeordneten Kontaktierungsanordnungen (30) zur elektrischen Kontaktierung des wenigstens einen elektronischen Bauelements (12) mit jeweils wenigstens einem ersten elektrischen Kontakt (31) und einem zweiten elektrischen Kontakt (32),
• **dadurch gekennzeichnet, dass** die ersten elektrischen Kontakte (31) der Mehrzahl an Kontaktierungsanordnungen (30) elektrisch verbunden sind und die zweiten elektrischen Kontakte (32) der Mehrzahl an Kontaktierungsanordnungen (30) elektrisch verbunden sind.

2. Paillette (1) nach Anspruch 1, **dadurch gekennzeichnet, dass** eine Anzahl der Kontaktierungsanordnungen (30) einer Zähligkeit der Rotationssymmetrie der Grundfläche (20) des Trägerelements (10) entspricht.

3. Paillette (1) nach Anspruch 1 oder 2, **dadurch gekennzeichnet, dass** die Grundfläche (20) des Trägerelements (10) als regelmäßiges Polygon ausgestaltet ist.

4. Paillette (1) nach einem der Ansprüche 1 bis 3, **dadurch gekennzeichnet, dass** die Mehrzahl an Kontaktierungsanordnungen (30) jeweils einen dritten elektrischen Kontakt oder jeweils weitere elektrische Kontakte aufweisen, wobei jeweils der dritte elektrische Kontakt oder jeweils die weiteren elektrischen Kontakte der Mehrzahl an Kontaktierungsanordnungen (30) elektrisch verbunden sind.

5. Paillette (1) nach einem der vorhergehenden Ansprüche, **dadurch gekennzeichnet, dass** die ersten elektrischen Kontakte (31), die zweiten elektrischen Kontakte (32) und/oder die dritten oder weiteren elektrischen Kontakte jeweils einer der Kontaktierungsanordnungen (30) unmittelbar benachbart zueinander angeordnet sind.

6. Paillette (1) nach einem der vorhergehenden Ansprüche, **dadurch gekennzeichnet, dass** die ersten elektrischen Kontakte (31), die zweiten elektrischen Kontakte (32) und/oder die dritten oder weiteren elektrischen Kontakte jeweils einer der Kontaktierungsanordnungen (30) im Wesentlichen an einem Randbereich, insbesondere entlang einer zu einer Seite (22) der Grundfläche (20) parallelen Linie, des Trägerelements (10) angeordnet sind.

7. Paillette (1) nach einem der vorhergehenden Ansprüche, **dadurch gekennzeichnet, dass** die ersten elektrischen Kontakte (31), die zweiten elektrischen Kontakte (32) und/oder die dritten oder weiteren elektrischen Kontakte als Kontaktbohrungen zur Aufnahme eines elektrisch leitfähigen Fadens (8) ausgebildet sind.

8. Paillette (1) nach einem der vorhergehenden Ansprüche, **dadurch gekennzeichnet, dass** das Trägerelement (10) wenigstens ein Zentrierelement (40) zum Ausrichten und/oder Fixieren der Paillette (1) während eines Anbringens an das Kleidungsstück (60) oder das Textilelement (60) aufweist, wobei das wenigstens eine Zentrierelement (40) vorzugsweise als in/an dem Trägerelement angeordnete/r Bohrung (41), Zentrieröffnung (42) und/oder Vorsprung (43) ausgestaltet ist.

9. Paillette (1) nach Anspruch 8, **dadurch gekennzeichnet, dass** eine Mehrzahl an Zentrierungselementen (40) rotationssymmetrisch an oder auf dem Trägerelement (10) angeordnet ist und eine Anzahl der Zentrierungselemente (40) mindestens einer Zähligkeit der Rotationssymmetrie der Grundfläche (20) des Trägerelements (10) entspricht.

10. Anordnung (2), umfassend wenigstens eine an einem Kleidungsstück (60) oder einem Textilelement (60) angebrachte oder integrierte Paillette (1) gemäß einem der Ansprüche 1 bis 9, sowie wenigstens einen ersten elektrisch leitfähigen Faden (8) und einen zweiten elektrisch leitfähigen Faden (8) zur mechanischen Befestigung der Paillette (1) an dem Kleidungsstück (60) oder dem Textilelement (60) und/oder zur elektrischen Kontaktierung der Paillette (1), wobei der erste elektrisch leitfähige Faden (8) mit einem der ersten elektrischen Kontakte (31) und der zweite elektrisch leitfähige Faden (8) mit einem der zweiten elektrischen Kontakte (32) verbunden ist.

11. Anordnung (2) nach Anspruch 10, **dadurch gekennzeichnet, dass** die wenigstens eine Paillette (1) mittels wenigstens eines, insbesondere als Bohrung 41, als Zentrieröffnung 42 und/oder als Vorsprung 43 ausgebildeten, Zentrierelements 40 an dem Kleidungsstück (60) oder dem Textilelement (60) befestigt ist.

12. Anordnung (2) nach Anspruch 10 oder 11, **dadurch gekennzeichnet, dass** die wenigstens eine Paillette (1) mit einer auf eine Außenseite des Textilelements (60) oder des Kleidungsstücks (60) weisenden Oberseite des Trägerelements (10) oder mit einer Unterseite des Trägerelements (10) an dem Kleidungsstück (60) oder dem Textilelement (60) angebracht oder integriert ist.

13. Anordnung (2) nach einem der Ansprüche 10 bis 12, **dadurch gekennzeichnet, dass** die Anordnung (2) wenigstens eine weitere an dem Kleidungsstück (60) oder dem Textilelement (60) angebrachte oder integrierte Paillette (1a, 1b, 1c, 1d) gemäß einem der Ansprüche 1 bis 9 aufweist, wobei die Grundflächen (20) beider Pailletten (1a, 1b, 1c, 1d) an dem Kleidungsstück (60) oder dem Textilelement (60), insbesondere entlang einer horizontalen und/oder vertikalen Achse, derart zueinander parallelverschoben sind, dass ihre Grundflächen (20) sich nicht überlappen.

14. Verfahren (100) zum Herstellen einer Anordnung (2) gemäß einem der Ansprüche 10 bis 13 mit den Schritten:
- Bereitstellen (101) wenigstens einer Paillette (1) über eine Zuführeinrichtung auf ein Kleidungsstück (60) oder ein Textilelement (60) derart, dass die Paillette (1) eine definierte oder definierbare Ausrichtung auf dem Kleidungsstück (60) oder dem Textilelement (60) aufweist; sowie
- Befestigen (102) und/oder elektrisches Kontaktieren (102) der wenigstens einen Paillette (1) mittels wenigstens eines ersten elektrisch leitfähigen Fadens (8) und eines zweiten elektrisch leitfähigen Fadens (8), wobei der erste elektrisch leitfähige Faden (8) mit einem der ersten elektrischen Kontakte (31) und der zweite elektrisch leitfähige Faden (8) mit einem der zweiten elektrischen Kontakte (32) verbunden wird.

## Claims

1. Functional paillette (1) for an item of clothing (60) or a textile element (60), comprising
• at least one carrier element (10) for at least one electronic component (12), wherein the carrier element (10) has a rotationally symmetrical basic surface area (20) with a multiple rotational symmetry,
• a plurality of contacting arrangements (30), which are arranged rotationally symmetrically in relation to each other on the carrier element (10), for electrically contacting the at least one electronic component (12), each contacting arrangement having at least a first electrical contact (31) and a second electrical contact (32),
• **characterized in that** the first electrical contacts (31) of the plurality of contacting arrangements (30) are electrically connected and the second electrical contacts (32) of the plurality of contacting arrangements (30) are electrically connected.

2. Paillette (1) according to Claim 1, **characterized in that** a number of the contacting arrangements (30) corresponds to a multiplicity of the rotational symmetry of the basic surface area (20) of the carrier element (10).

3. Paillette (1) according to Claim 1 or 2, **characterized in that** the basic surface area (20) of the carrier element (10) is configured as a regular polygon.

4. Paillette (1) according to any of Claims 1 to 3, **characterized in that** the plurality of contacting arrangements (30) each have a third electrical contact or each have further electrical contacts, wherein the third electrical contact or the further electrical contacts of the plurality of contacting arrangements (30) are electrically connected in each case.

5. Paillette (1) according to any of the preceding claims, **characterized in that** the first electrical contacts (31), the second electrical contacts (32) and/or the third or further electrical contacts of each one of the contacting arrangements (30) are arranged directly adjacent to each other.

6. Paillette (1) according to any of the preceding claims, **characterized in that** the first electrical contacts (31), the second electrical contacts (32) and/or the third or further electrical contacts of each one of the contacting arrangements (30) are arranged substantially at an edge region, in particular along a line parallel to one side (22) of the basic surface area (20), of the carrier element (10).

7. Paillette (1) according to any of the preceding claims, **characterized in that** the first electrical contacts (31), the second electrical contacts (32) and/or the third or further electrical contacts are formed as contact holes for receiving an electrically conductive thread (8).

8. Paillette (1) according to any of the preceding claims, **characterized in that** the carrier element (10) has at least one centring element (40) for aligning and/or fixing the paillette (1) as it is attached to the item of clothing (60) or the textile element (60), wherein the at least one centring element (40) is preferably configured as a bore (41), centring opening (42) and/or projection (43) arranged in/on the carrier element.

9. Paillette (1) according to Claim 8, **characterized in that** a plurality of centring elements (40) are arranged rotationally symmetrically at or on the carrier element (10) and a number of the centring elements (40) corresponds at least to a multiplicity of the rotational symmetry of the basic surface area (20) of the carrier element (10).

10. Arrangement (2), comprising at least one paillette (1) according to any of Claims 1 to 9 attached to or integrated with an item of clothing (60) or a textile element (60), and at least a first electrically conductive thread (8) and a second electrically conductive thread (8) for mechanically fastening the paillette (1) to the item of clothing (60) or the textile element (60) and/or for electrically contacting the paillette (1), wherein the first electrically conductive thread (8) is connected to one of the first electrical contacts (31) and the second electrically conductive thread (8) is connected to one of the second electrical contacts (32).

11. Arrangement (2) according to Claim 10, **characterized in that** the at least one paillette (1) is fastened to the item of clothing (60) or the textile element (60) by means of at least one centring element 40, in particular formed as a bore 41, as a centring opening 42 and/or as a projection 43.

12. Arrangement (2) according to Claim 10 or 11, **characterized in that** the at least one paillette (1) is attached to or integrated with the item of clothing (60) or the textile element (60) by way of a top side of the carrier element (10), the top side facing an outer side of the textile element (60) or the item of clothing (60), or by way of a bottom side of the carrier element (10).

13. Arrangement (2) according to any of Claims 10 to 12, **characterized in that** the arrangement (2) has at least one further paillette (1a, 1b, 1c, 1d) according to any of Claims 1 to 9 attached to or integrated with the item of clothing (60) or the textile element (60), wherein the basic surface areas (20) of both paillettes (1a, 1b, 1c, 1d) are displaced in parallel in relation to each other on the item of clothing (60) or the textile element (60), in particular along a horizontal and/or vertical axis, in such a way that their basic surface areas (20) do not overlap.

14. Method (100) for producing an arrangement (2) according to any of Claims 10 to 13, comprising the steps of:
- providing (101) at least one paillette (1) via a feed device on an item of clothing (60) or a textile element (60) in such a way that the paillette (1) has a defined or definable orientation on the item of clothing (60) or the textile element (60); and
- fastening (102) and/or electrically contacting (102) the at least one paillette (1) by means of at least a first electrically conductive thread (8) and a second electrically conductive thread (8), wherein the first electrically conductive thread (8) is connected to one of the first electrical contacts (31) and the second electrically conductive thread (8) is connected to one of the second electrical contacts (32).

## Revendications

1. Paillette fonctionnelle (1) pour un vêtement (60) ou un élément textile (60), comprenant
• au moins un élément de support (10) pour au moins un composant électronique (12), l'élément de support (10) présentant une surface de base (20) symétrique en rotation ayant une symétrie de rotation multiple,
• une pluralité d'agencements de mise en contact (30) disposés de manière symétrique en rotation les uns par rapport aux autres sur l'élément de support (10), pour la mise en contact électrique dudit au moins un composant électrique (12) avec respectivement au moins un premier contact électrique (31) et un deuxième contact électrique (32),
• **caractérisée en ce que** les premiers contacts électriques (31) de la pluralité d'agencements de mise en contact (30) sont connectés électriquement, et les deuxièmes contacts électriques (32) de la pluralité d'agencements de mise en contact (30) sont connectés électriquement.

2. Paillette (1) selon la revendication 1, **caractérisée en ce qu'**un nombre des agencements de mise en contact (30) correspond à une multiplicité de la symétrie en rotation de la surface de base (20) de l'élément de support (10).

3. Paillette (1) selon la revendication 1 ou 2, **caractérisée en ce que** la surface de base (20) de l'élément de support (10) est configurée sous forme de polygone régulier.

4. Paillette (1) selon l'une quelconque des revendications 1 à 3, **caractérisée en ce que** la pluralité d'agencements de mise en contact (30) présente respectivement un troisième contact électrique ou respectivement d'autres contacts électriques, dans laquelle respectivement le troisième contact électrique ou respectivement les autres contacts électriques de la pluralité d'agencements de mise en contact (30) sont connectés électriquement.

5. Paillette (1) selon l'une quelconque des revendications précédentes, **caractérisée en ce que** les premiers contacts électriques (31), les deuxièmes contacts électriques (32) et/ou les troisièmes ou d'autres contacts électriques sont respectivement disposés de manière directement voisine d'un des agencements de mise en contact (30).

6. Paillette (1) selon l'une quelconque des revendications précédentes, **caractérisée en ce que** les premiers contacts électriques (31), les deuxièmes contacts électriques (32) et/ou les troisièmes ou d'autres contacts électriques respectivement d'un des agencements de mise en contact (30) sont agencés substantiellement dans une zone marginale, en particulier le long d'une ligne parallèle à un côté (22) de la surface de base (20), de l'élément de support (10).

7. Paillette (1) selon l'une quelconque des revendications précédentes, **caractérisée en ce que** les premiers contacts électriques (31), les deuxièmes contacts électriques (32) et/ou les troisièmes ou d'autres contacts électriques sont réalisés sous forme d'alésages de contact destinés à recevoir un fil (8) électriquement conducteur.

8. Paillette (1) selon l'une quelconque des revendications précédentes, **caractérisée en ce que** l'élément de support (10) présente au moins un élément de centrage (40) pour aligner et/ou fixer la paillette (1) pendant qu'elle est attachée au vêtement (60) ou à l'élément textile (60), dans laquelle ledit au moins un élément de centrage (40) est configuré de préférence sous la forme d'un alésage (41), d'une ouverture de centrage (42) et/ou d'une saillie (43) disposé(e) dans ou sur l'élément de support.

9. Paillette (1) selon la revendication 8, **caractérisée en ce qu'**une pluralité d'éléments de centrage (40) est disposée de manière symétrique en rotation au niveau de ou sur l'élément de support (10), et un nombre des éléments de centrage (40) correspond au moins à une multiplicité de la symétrie en rotation de la surface de base (20) de l'élément de support (10).

10. Agencement (2), comprenant au moins une paillette (1) selon l'une quelconque des revendications 1 à 9, attachée ou intégrée à un vêtement (60) ou à un élément textile (60), ainsi qu'au moins un premier fil (8) électriquement conducteur et un deuxième fil (8) électriquement conducteur pour la fixation mécanique de la paillette (1) au vêtement (60) ou à l'élément textile (60) et/ou pour la mise en contact électrique de la paillette (1), dans lequel le premier fil (8) électriquement conducteur est relié à l'un des premiers contacts électriques (31), et le deuxième fil (8) électriquement conducteur est relié à l'un des deuxièmes contacts électriques (32).

11. Agencement (2) selon la revendication 10, **caractérisé en ce que** ladite au moins une paillette (1) est fixée au vêtement (60) ou à l'élément textile (60) au moyen d'au moins un élément de centrage 40, en particulier réalisé sous forme d'alésage 41, d'ouverture de centrage 42 et/ou de saillie 43.

12. Agencement (2) selon la revendication 10 ou 11, **caractérisé en ce que** ladite au moins une paillette (1) est attachée ou intégrée au vêtement (60) ou à l'élément textile (60) par une surface supérieure de l'élément de support (10) tournée vers un côté extérieur de l'élément textile (60) ou du vêtement (60) ou par une surface inférieure de l'élément de support (10).

13. Agencement (2) selon l'une quelconque des revendications 10 à 12, **caractérisé en ce que** l'agencement (2) présente au moins une autre paillette (1a, 1b, 1c, 1d) selon l'une quelconque des revendications 1 à 9 attachée ou intégrée au vêtement (60) ou à l'élément textile (60), dans lequel les surfaces de base (20) des deux paillettes (1a, 1b, 1c, 1d) sur le vêtement (60) ou l'élément textile (60) sont décalées en parallèle l'une par rapport à l'autre, en particulier le long d'un axe horizontal et/ou vertical, de telle sorte que leurs surfaces de base (20) ne se chevauchent pas.

14. Procédé (100) permettant de fabriquer un agencement (2) selon l'une quelconque des revendications 10 à 13, comprenant les étapes consistant à :
- fournir (101) au moins une paillette (1) par l'intermédiaire d'un équipement d'alimentation sur un vêtement (60) ou un élément textile (60) de telle sorte que la paillette (1) présente un alignement défini ou définissable sur le vêtement (60) ou l'élément textile (60) ; ainsi que
- fixer (102) et/ou mettre en contact électrique (102) ladite au moins une paillette (1) au moyen d'au moins un premier fil (8) électriquement conducteur et d'un deuxième fil (8) électriquement conducteur, dans lequel le premier fil (8) électriquement conducteur est relié à l'un des premiers contacts électriques (31) et le deuxième fil (8) électriquement conducteur est relié à l'un des deuxièmes contacts électriques (32).
